Europäisches Patentamt

European Patent Office

Office européen des brevets

(19)

(11) Publication number: **0 232 951 B1**

(12) **EUROPEAN PATENT SPECIFICATION**

(45) Date of publication of patent specification: **16.10.91**

(51) Int. Cl.⁵: **F41G  7/00, G01S 3/78, G01S 1/70, H01L 31/00, H01L 27/14**

(21) Application number: **87200220.9**

(22) Date of filing: **11.02.87**

(54) Information transmission system.

(30) Priority: **14.02.86 GB 8603682**

(43) Date of publication of application:
**19.08.87 Bulletin 87/34**

(45) Publication of the grant of the patent:
**16.10.91 Bulletin  91/42**

(84) Designated Contracting States:
**BE CH DE ES FR GB GR IT LI NL SE**

(56) References cited:
**DE-A- 2 537 898**
**GB-A- 1 569 306**
**GB-A- 2 087 185**
**US-A- 3 912 927**

(73) Proprietor: **PHILIPS ELECTRONIC AND ASSO-CIATED INDUSTRIES LIMITED**
**Philips House 188 Tottenham Court Road**
**London W1P 9LE(GB)**

(84) Designated Contracting States:
**GB**

Proprietor: **N.V. Philips' Gloeilampenfabrieken**

**Groenewoudseweg 1**
**NL-5621 BA Eindhoven(NL)**

(84) Designated Contracting States:
**BE CH DE ES FR GR IT LI NL SE**

(72) Inventor: **Morten, Frank Donald**
**Mullard Southampton Millbrook Industrial Estate**
**Southampton Hants S09 7BH(GB)**
Inventor: **Forder, Stuart**
**Mullard Southampton Millbrook Industrial Estate**
**Southampton Hants S09 7BH(GB)**

(74) Representative: **Boxall, Robin John et al**
**PHILIPS ELECTRONICS Patents and Trade Marks Department Philips House 188 Tottenham Court Road**
**London W1P 9LE(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The invention relates to a process for sending information along a beam of radiation of a selected wavelength from a radiation transmitter to a radiation receiver in which the radiation intensity at the receiver falls as a function of time elapsed from a start of information transmission, and further relates to an information transmission system adapted to operate such a process. Such a transmission system and process may be employed in a guided missile system to transmit information from the missile launch point to the missile, while in flight, to guide it to its target.

Wire-guided anti-tank missiles are known in which an operator observes a target tank using an imaging system, typically a thermal imaging system, and aligns a graticule with the target. The missile is then fired and guided to the target, either by the operator or by an automatic guidance system, by means of guidance signals fed to the missile along a wire which the missile unwinds behind itself and leaves stationary on the ground as it moves toward the target. Such a missile guidance system is described in British Patent Specification GB-A-2 087 185.

In the system of GB-A-2 087 185, the location of the missile in the scene is transmitted to the operator by a radiation link from the missile which is equipped with a rearwards facing tracer hot point acting as the radiation transmitter. The radiation receiver in this case is located at the missile launch and/or guidance point (i.e. not on the moving missile), and may form part of the thermal imaging system which the operator uses to observe the target in the scene. It is known for this receiver to comprise a semiconductor radiation detector, for example of cadmium mercury telluride as described in GB-A-2 087 185 and, for example, British Patent Specification GB-A-1 569 306. Due to their semiconductor band-gap properties, these detectors have a peak in detectivity as a function of wavelength. Their detectivity rises as a function of falling detector temperature so that these detectors are normally operated at a reduced temperature obtained by cooling the detector before operation. These specific detectivity characteristics of the semiconductor radiation detectors are not described in either GB-A-2 087 185 or GB-A-1 569 306, but such characteristics are described in, for example, an article by J.L. Schmit in Journal of Applied Physics Volume 41, No. 7 on pages 2876 to 2879.

It is proposed to replace the wire link to the missile by a radiation link comprising a source of radiation at the missile launch point which can be modulated with the guidance information. The radiation is formed into a beam of angular width covering the target and the expected range of lateral movement of the missile on its way to the target. The missile comprises a rearwards facing radiation collection and detection system which receives the modulated radiation from the source and converts it into appropriate guidance signals for the missile flight path control system. It is desirable that the radiation source should produce non-visible radiation for obvious security reasons and should also be infra-red radiation of a sufficiently long wavelength that the radiation can penetrate mist, fog or smoke as much as possible. A typically convenient source of radiation is the carbon dioxide laser which operates at a wavelength of 10.6 $\mu$m.

In this situation it would be beneficial to use cooled infra-red detectors (for example of cadmium-mercury telluride) to detect the radiation with adequate sensitivity. Stored electrical energy or compressed gas is then required within the missile to provide detector cooling in a form to be instantly available on firing the missile but to have a long storage life. Unavoidably the stored energy is limited and therefore detector cooling cannot start until the missile is fired, and there will be a delay before the detector temperature falls to its operating value. From the instant of firing the distance between the missile and the source increases, growing more rapidly as the missile accelerates under booster rocket power to its cruise velocity. Since the received radiation energy at the missile will fall inversely as the square of missile distance, the received energy will fall rapidly, exacerbating the effect of the delay in detector sensitivity rise.

It is an object of the invention to provide an information transmission system and process in which, when used for such missile guidance, the detector sensitivity, while low at launch, is sufficient to provide guidance signals at short range and in which the detector sensitivity rises with increasing missile range from the launch point.

According to a first aspect of the invention there is provided a process for sending information along a beam of radiation of a selected wavelength from a radiation transmitter to a radiation receiver while the radiation intensity at the receiver falls as a function of time elapsed from a start of information transmission, the receiver comprising a compound-semiconductor radiation detector having a peak in detectivity as a function of wavelength and whose detectivity rises as a function of falling detector temperature, which process is characterised in that the detector temperature is reduced progressively from the start of transmission towards a final operating temperature, the semiconductor material of the detector providing a detectivity-temperature characteristic whose peak in detectivity at the start occurs at a wavelength less than the selected wavelength of the beam and progressively increases in wavelength up to at least the selected wavelength as the detector temperature falls during the transmission towards the final operating temperature, and in that the transmission and reception of the information starts before the detector temperature reaches the final operating temperature and when the detectivity of the detector at the selected wavelength of the beam is less than its final value at the final operating temperature.

According to a second aspect of the invention there is provided an information transmission system adapted for sending information along a beam of radiation of a selected wavelength by a process in accordance with the first aspect of the invention, characterised in that the receiver comprises cooling means which operates to control the detector temperature and which is organised to reduce progressively the detector temperature from the start of transmission towards a final operating temperature, in that the system has start means organised to start the transmission and reception of the information before the detector temperature reaches the final operating temperature and when the detectivity of the detector at the selected wavelength of the beam is less than its final value at the final operating temperature and in that the semiconductor material of the detector is such as to provide a detectivity-temperature characteristic whose peak in detectivity at the temperature at the start of the information transmission occurs at a wavelength less than the selected wavelength of the beam and progressively increases in wavelength up to at least the selected wavelength as the detector temperature falls towards the final operating temperature.

In accordance with the invention, information is transmitted and received via a beam of radiation of a selected wavelength while the peak in detectivity of the detector increases in wavelength from less than the selected wavelength up to at least the selected wavelength as the detector temperature falls towards its final value. The invention thereby provides a large rise in detectivity as the detector cools. This is due partly to the fact that the curves of detectivity as a function of wavelength are steep on the long wavelength side of the peak, that is, towards the cut-off wavelength. Thus a bodily shift of the whole curve to longer wavelengths due to cooling will produce a large change in detectivity at a fixed wavelength selected at about the cut-off wavelength at high temperature. The rise in detectivity is also assisted by the rise in detectivity at all wavelengths as a function of falling temperature. The detectivity curve at a high temperature lies entirely beneath the detectivity curve at a low temperature.

An embodiment of the invention will now be described by way of example with reference to the accompanying drawings in which,

Figure 1 shows a missile guidance system in schematic form,

Figure 2 shows the radiation collection and detection system on the missile of Figure 1,

Figures 3 and 4 show curves of the variation of detector detectivity with wavelength at various values of detector temperature, and

Figure 5 shows the variation of long wavelength cut-off in a cadmium mercury telluride detector with detector temperature for various values of the proportion of cadmium to mercury in the detector.

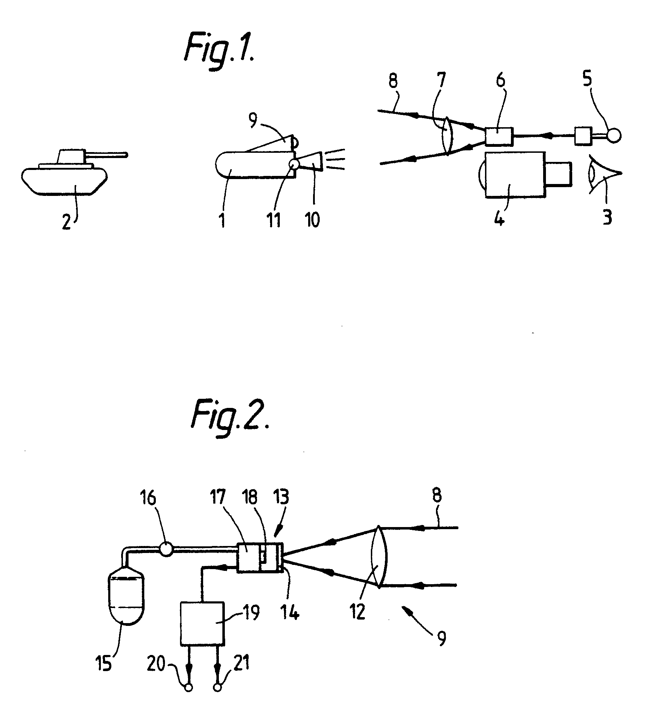

Referring to Figure 1, a missile guidance system is shown schematically to illustrate the guidance of a missile 1 towards a target 2, the missile being shown in mid-course. At the missile launch point an operator 3 views the missile and target using an imaging system 4 which comprises means for forming an enlarged image of the missile and target and for injecting an aiming graticule into the enlarged image to assist the operator. Depending on the degree of misalignment between the missile flight path and the target, the operator makes manual adjustments to a joystick 5 to generate correction signals which are applied to modulate a radiation source 6 comprising a carbon dioxide laser emitting radiation at 10.6µm wavelength. An objective system 7 forms a radiation beam 8 from the radiation emitted by the source. The beam is arranged to have an angular spread sufficient to cover the expected range of lateral movement of the missile 1 on its path to the target 2. The missile comprises a rearwards facing radiation collection and detection system 9 which receives the beam 8 and decodes the missile guidance signals from it. The guidance signals are applied to means to alter the missile flight path. In this case the rocket propulsion motor 10 is mounted in gimbals 11 so that the direction of rocket thrust relative to the missile body can be altered to effect changes in missile movement direction. The guidance signals are applied to gimbal rotation devices not shown.

The radiation collection and detection system 9 is shown schematically in Figure 2. An objective lens 12 focusses the incoming radiation 8 onto a radiation detection assembly 13. The assembly comprises an input window 14, an infra-red detector 18 mounted upon a substrate, and means for cooling the substrate and detector. The cooling means comprises a reservoir 15 of highly compressed nitrogen or argon gas (100 atmospheres), and a valve 16 for controlling the flow of gas to a regenerative cooler 17 shown schematically. The final operating value of detector temperature reached is 77K or 89K respectively. The initial rate of cooling is very rapid, a temperature of 150K being reached in 0.6 seconds. The detector output signal is passed to processing and decoding circuit 19 which produces an up/down guidance signal at output 20 and a left/right guidance signal at output 21 for the gimbal rotation devices.

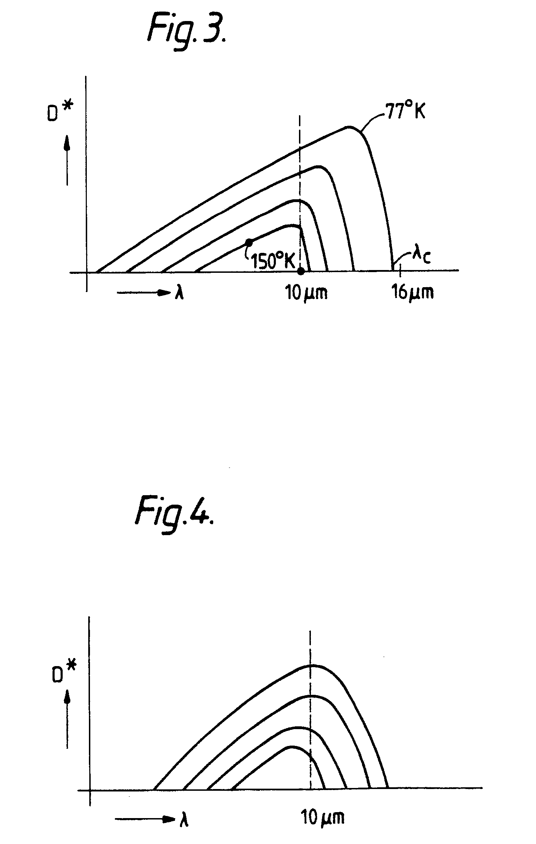

The detector 18 is a photoconductive cadmium mercury telluride (CMT) semiconductor detector. In practical detectors the ratio of cadmium (Cd) to mercury (Hg) can be varied to produce detectors having different properties, the general formula of the compound being given as $Hg_{1-x} Cd_x Te$, the variable x giving the relative proportions of Cd to Hg. A second independent variable which can be chosen to modify the detector properties is the temperature at which the detector is operated. Figure 3 shows the variation of detectivity, D*, as a function of the wavelength, λ, of the radiation being received. D* effectively gives the signal to noise ratio achieved in the detector output for unit radiation power received at a specified wavelength, the signal being confined to unit bandwidth. Thus, assuming adequate signal amplification is subsequently available, D* gives the detector sensitivity for useful signal output.

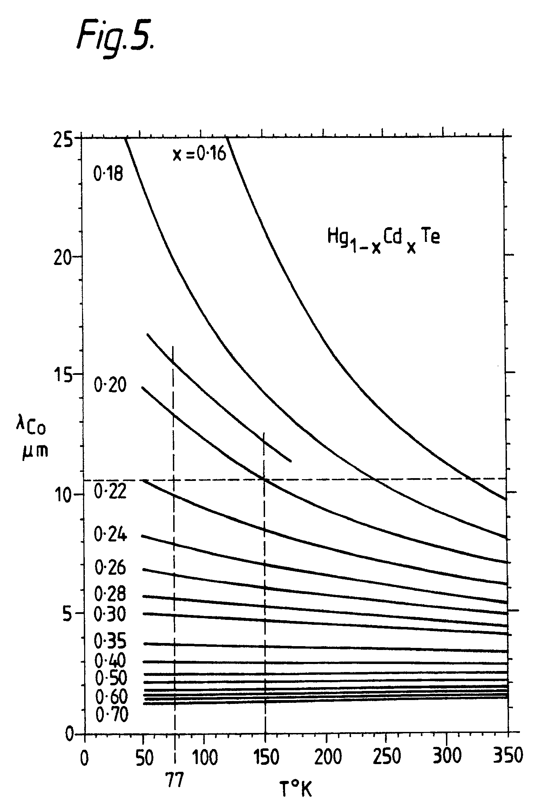

Figure 3 shows the variation of $D^*$ as a function of λ for four values of temperature T in degrees Kelvin (K) in a CMT detector with a particular value of x. D* rises as temperature falls and, importantly, the long wavelength cut-off $λ_c$ of detectivity moves to longer wavelengths. In this case $λ_c$ rises from above 10μm at 150K towards 16μm at 77K. Figure 4 shows the same information as Figure 3 but for a detector of a different value of x. It is to be noted that the fall in D* after the peak toward $λ_c$ is steeper than the rise in D* with λ below the peak. The effect of variation of x on the value of $λ_c$ as a function of temperature is summarised in Figure 5 which is given on page 2877 of the article by J. L. Schmit in Journal of Applied Physics Volume 41 No. 7 and in which the specific values $λ_{co}$ for the cut-off are derived from equations (1) and (2) given in said Journal of Applied Physics article. From Figure 5 it will be seen that lower values of x give a greater shift of $λ_c$ to longer wavelengths as a function of falling temperature. Thus a value of x can be chosen in relation to a wavelength that has been selected for the source 6 of Figure 1, in relation to the known fall of temperature with time produced by the cooling device and in relation to the known increase in missile range from the launch point so that a small but adequate detectivity is available very shortly after launch followed by a marked increase of detectivity as the missile range increases.

It is to be noted that the effect of the inverse square law fall in received energy as a function of missile range is to produce much larger percentage reductions in received energy for a given change in range at short ranges than does the same change in range at long ranges. Thus large increases in detector sensitivity are desirable during the early stages of guidance for it is then that the greatest percentage reductions in received energy occur. It is the selection of wavelength of the radiation beam in relation to the choice of shape and position of the detectivity curve of the detector at its temperature at the start of transmission in accordance with the invention which achieves this rise of detectivity at the right time during the missile flight.

In Figures 3 and 4 a line at 10μm wavelength is shown, close to the carbon dioxide laser wavelength of 10.6μm. In the cooling example quoted, 0.6 seconds after launch when T = 150K, $λ_c$ has risen so that D* has a useful value at 10.6μm; this wavelength then lies just inside the D* curve for 150K but above the wavelength at which the peak D* occurs at this temperature. Further fall of detector temperature not only produces further shift of $λ_c$ to longer wavelengths but also increases the peak D*. The peak D* also shifts to longer wavelengths. In Figure 4 the shift of peak D* is not so great. Figure 3 illustrates a situation where the shift of the D* curves with cooling from 150K to 77K results in the peak D* shifting to a wavelength longer than the 10.6μm wavelength of the laser beam 8, so that at this final stage the detector 18 is operating at a lower detectivity than at its peak. Figure 4 illustrates a situation where the D* peak is shifted to approximately the wavelength of the beam 8. From Figure 5 it will be seen how values of x between 0.20 and 0.18 can be chosen so that at 150K $λ_c$ is just at or above 10.6μm and thereafter shifts towards 16μm at a temperature of 77K.

The invention has been described so far in relation to a particular ternary compound, CMT. Other ternary compounds could be used. Lead tin telluride for example might be employed provided its high coefficient of thermal expansion, 10ppm/degree C, is acceptable. CMT has a lower thermal expansion and can be grown epitaxially on cadmium telluride, sapphire or gallium arsenide. Quaternary compounds may also be used for the detector. In particular, CMT may be used in which a small part of the tellurium is replaced by selenium. This achieves a beter lattice match when growing the detector epitaxially and hence produces a smaller number of dislocations in the detector.

It has been stated above that the drawings illustrate examples of an embodiment of the invention and, in order to avoid any misunderstanding, it is hereby further stated that, in the following claims, where technical features mentioned in any claim are followed by reference signs relating to features in the drawings and placed between parentheses, these reference signs have been included in accordance with Rule 29(7) EPC for the sole purpose of facilitating comprehension of the claim, by reference to an example.

## Claims

1. A process for sending information along a beam (8) of radiation of a selected wavelength from a radiation transmitter (6) to a radiation receiver (9) while the radiation intensity at the receiver falls as a function of time elapsed from a start of information transmission, the receiver (9) comprising a compound-semiconductor radiation detector (18) having a peak in detectivity as a function of wavelength and whose detectivity rises as a function of falling detector temperature, which process is characterised in that the detector temperature is progressively reduced by cooling means (15,16,17) from the start of transmission towards a final operating temperature, the semiconductor material of the detector (18) providing a detectivity-temperature characteristic whose peak in detectivity at the start occurs at a wavelength less than the selected wavelength of the beam and progressively increases in wavelength up to at least the selected wavelength as the detector temperature falls during the transmission towards the final operating temperature, and in that the transmission and reception of the information starts before the detector temperature reaches the final operating temperature and when the detectivity of the detector at the selected wavelength of the beam is less than its final value at the final operating temperature.

2. A process as claimed in Claim 1, further characterised in that the detector temperature is reduced until at the final operating temperature the peak in detectivity is at a wavelength longer than the selected wavelength, and so the detector (18) when at that final temperature operates with a lower detectivity for the selected wavelength than said peak.

3. A process as claimed in Claim 1 or Claim 2, further characterised in that the receiver (9) recedes from the transmitter (6) as a function of time from the start of transmission, so producing the fall in received radiation intensity.

4. A process as claimed in Claim 3, further characterised in that the receiver (9) is mounted in a guided missile (1), in that the start of transmission is the launch instant of the missile, and in that the information transmitted is missile guidance information.

5. A process as claimed in any one of the preceding claims, further characterised in that the detector (18) is a cadmium mercury telluride photoconductive detector, and in that the relative proportions of cadmium and mercury are selected so that the long wavelength cut-off of the detector substantially equals the selected wavelength before cooling to the final operating temperature.

6. A process as claimed in any one of the preceding claims characterised in that the selected wavelength is $10.6\mu m$.

7. An information transmission system adapted for sending information by a process as claimed in any one of Claims 1 to 4, the system including a transmitter (6) and a receiver (9) for transmitting and receiving a beam (8) of radiation of a selected wavelength, the receiver (9) comprising a compound-semiconductor radiation detector (18) having a peak in detectivity as a function of wavelength and whose detectivity rises as a function of falling detector temperature and characterised in that the receiver (9) comprises cooling means (15,16,17) which operates to control the detector temperature and which is organised to reduce progressively the detector temperature from the start of transmission towards a final operating temperature, in that the system has start means organised to start the transmission and reception of the information before the detector temperature reaches the final operating temperature and when the detectivity of the detector at the selected wavelength of the beam is less than its final value at the final operating temperature, and in that the semiconductor material of the detector (18) is such as to provide a detectivity-temperature characteristic whose peak in detectivity at the temperature at the start of the information transmission occurs at a wavelength less than the selected wavelength of the beam and progressively increases in wavelength up to at least the selected wavelength as the detector temperature falls towards the final operating temperature.

8. An information transmission system as claimed in Claim 7, characterised in that the detector (18) is a cadmium mercury telluride photoconductive detector, and in that the relative proportions of cadmium and mercury are selected so that the long wavelength cut-off of the detector substantially equals the selected wavelength before cooling to the final operating temperature.

9. An information transmission system as claimed in Claim 7 or Claim 8, wherein the transmitter is an infrared laser (6) of 10.6μm wavelength for generating the beam (8) of radiation of the selected wavelength.

## Revendications

1. Procédé pour transmettre de l'information par l'intermédiaire d'un faisceau de rayonnement (8) d'une longueur d'onde sélectionnée à partir d'un émetteur de rayonnement (6) à un récepteur de rayonnement (9) alors que l'intensité de rayonnement au récepteur diminue en fonction du temps écoulé à partir du début d'émission d'information, le récepteur (9) comportant un détecteur de rayonnement semi-conducteur composé (18) qui présente une crête en sensibilité en fonction de la longueur d'onde et dont la sensibilité augmente en fonction de la baisse de la température du détecteur, lequel procédé est caractérisé en ce que la température du détecteur est réduite progressivement par des moyens de refroidissement (15, 16, 17) à partir du début de l'émission jusqu'à une température de fonctionnement finale, le matériau semiconducteur du détecteur (18) fournissant une caractéristique sensibilité-température, dont la crête en sensibilité au début se produit à une longueur d'onde inférieure à la longueur d'onde sélectionnée du faisceau et augmente progressivement en longueur d'onde jusqu'au moins la longueur d'onde sélectionnée lorsque la température du détecteur diminue pendant l'émission jusqu'à la température de fonctionnement finale, et en ce que l'émission et la réception de l'information commencent avant que la température du détecteur n'atteigne la température de fonctionnement finale et lorsque la sensibilité du détecteur à la longueur d'onde sélectionnée du faisceau est inférieure à sa valeur finale à la température de fonctionnement finale.

2. Procédé selon la revendication 1, caractérisé davantage en ce que la température du détecteur est diminuée jusqu'à la température de fonctionnement finale, la crête en sensibilité est à une longueur d'onde supérieure à la longueur d'onde sélectionnée de façon que le détecteur (18) fonctionne à cette température finale avec une sensibilité plus faible pour la longueur d'onde sélectionnée que ladite crête.

3. Procédé selon la revendication 1 ou 2, caractérisé davantage en ce que le récepteur (9) s'éloigne de l'émetteur en fonction du temps à partir du début d'émission ce qui provoque la chute en intensité du rayonnement reçu.

4. Procédé selon la revendication 3, caractérisé en ce que le récepteur (9) est monté dans une missile guidée (1), en ce que le début de l'émission est l'instant de lancement de la missile et en ce que l'information émise est l'information de guidage de la missile.

5. Procédé selon l'une des revendications précédentes, caractérisé davantage en ce que le détecteur (18) est un détecteur photoconducteur en tellurure de cadmium-mercure et en ce que les proportions relatives du cadmium et du mercure sont choisies de façon que la longueur d'onde maximale à laquelle est sensible le détecteur soit pratiquement égale à la longueur d'onde sélectionnée avant le refroidissement jusqu'à la température de fonctionnement finale.

6. Procédé selon l'une des revendications précédentes, caractérisé en ce que la longueur d'onde sélectionnée est de 10,6 μm.

7. Système d'émission d'information adapté à l'émission d'information, notamment de l'information de guidage de missile par un procédé selon l'une des revendications 1 à 4, le système étant muni d'un émetteur (6) et d'un récepteur (9) pour l'émission et la réception d'un faisceau de rayonnement (8) d'une longueur d'onde sélectionnée, le récepteur (9) comportant un détecteur de rayonnement semiconducteur composé (18) qui présente une crête en sensibilité en fonction de la longueur d'onde et dont la sensibilité augmente en fonction de la chute de la température du détecteur, caractérisé en ce que le récepteur (9) est muni de moyens de refroidissement (15, 16, 17) qui fonctionnent pour régler la température du détecteur et qui sont conçus pour diminuer progressivement la température du détecteur à partir du démarrage de l'émission jusqu'à une température de fonctionnement finale, en ce que le système est muni de moyens de démarrage conçus pour démarrer l'émission et la réception de l'information avant que la température du détecteur n'atteigne la température de fonctionnement finale et lorsque la sensibilité du détecteur à la longueur d'onde sélectionnée du faisceau est inférieure à sa valeur finale à la température de fonctionnement finale, et en ce que le matériau semiconducteur du détecteur (18) est tel qu'il fournit une caractéristique sensibilité-température dont la crête en sensibilité à la température au démarrage de l'émission d'information se produit à une longueur d'onde inférieure à la longueur d'onde sélectionnée du faisceau et augmente progressivement en longueur d'onde jusqu'au moins la longueur d'onde sélectionnée lorsque la température du détecteur diminue jusqu'à la température de fonctionnement finale.

8.  Système d'émission d'information selon la revendication 7, caractérisé en ce que le détecteur (18) est un détecteur photoconducteur en tellurure de cadmium-mercure, en ce que les proportions relatives du cadmium et du mercure sont choisies de façon que la longueur maximale à laquelle le détecteur est sensible soit pratiquement égale à la longueur d'onde sélectionnée avant le refroidissement jusqu'à la température de fonctionnement finale.

9.  Système d'émission d'information selon la revendication 7 ou la revendication 8, dans lequel l'émetteur est un laser infra-rouge (6) d'une longueur d'onde de 10,6 $\mu$m pour la formation d'un faisceau de rayonnement (8) de la longueur d'onde sélectionnée.

**Patentansprüche**

1.  Verfahren zum Übertragen von Information über ein Strahlungsbündel (8) mit einer ausgewählten Wellenlänge von einem Strahlungssender (6) nach einem Strahlungsempfänger (9), wobei die Strahlungsintensität beim Empfänger in Abhängigkeit von der vergangenen Zeit nach einem Anfang von Informationsübertragung nachläßt, der Empfänger (9) einen zusammengesetzten Halbleiter-Strahlungsdetektor (18) mit einer Spitze in der Detektionsempfindlichkeit abhängig von Wellenlänge enthält und dessen Detektionsempfindlichkeit abhängig von abfallender Detektortemperatur ansteigt, dadurch gekennzeichnet, daß die Detektortemperatur vom Übertragungsanfang mit Kühlmitteln (15,16,17) progressiv verringert wird nach einer Betriebs-Endtemperatur das Halbleitermaterial des Detektors (18) eine Detektionsempfindligkeit/Temperatur-Kennlinie schafft, deren Empfindlichkeitsspitze am Anfang bei einer Wellenlänge auftritt, die kleiner ist als die gewählte Wellenlänge des Bündels, und dessen Wellenlänge bei abfallender Detektortemperatur während der Übertragung auf die Betriebs-Endtemperatur progressiv ansteigt, wenigstens bis zur gewählten Wellenlänge und daß die Übertragung und der Empfang der Information anfangen, bevor die Detektortemperatur die Betriebs-Endtemperatur erreicht und wenn die Detektionsempfindlichkeit des Detektors bei der gewählten Wellenlänge des Bündels geringer ist als ihr Endwert bei der Betriebs-Endtemperatur.

2.  Verfahren nach Anspruch 1, dadurch gekennzeichnet, daß die Detektortemperatur verringert wird, bis bei der Betriebs-Endtemperatur die Detektionsempfindlichkeitsspitze bei einer Wellenlänge liegt, die länger ist als die gewählte Wellenlänge, wodurch der Detektor (18) auf der Betriebs-Endtemperatur mit einer niedrigeren Detektionsempfindlichkeit für die gewählte Wellenlänge als die erwähnte Spitze arbeitet.

3.  Verfahren nach Anspruch 1 oder 2, dadurch gekennzeichnet, daß der Empfänger (9) vom Anfang der Übertragung zeitabhängig vom Sender zurückweicht, wodurch der Abfall in empfangener Strahlungsintensität verursacht wird.

4.  Verfahren nach Anspruch 3, dadurch gekennzeichnet, daß der Empfänger (9) in einem ferngelenkten Flugkörper (1) angebracht ist, daß der Übertragungsanfang der Abschußzeitpunkt des Flugkörpers ist, und daß die übertragene Information Flugkörperfernlenkinformation ist.

5.  Verfahren nach einem der vorangehenden Ansprüche, dadurch gekennzeichnet, daß der Detektor (18) ein photoleitender Kadmium-Quecksilber-Tellurid-Detektor ist, und daß die relativen Anteile von Kadmium und Quecksilber derart gewählt sind, daß die obere Abschneidwellenlänge des Detektors im wesentlichen gleich der gewählten Wellenlänge vor dem Erkalten auf die Betriebs-Endtemperatur ist.

6.  Verfahren nach einem der vorangehenden Ansprüche, noch dadurch gekennzeichnet, daß die gewählte Wellenlänge 10,6 $\mu$m beträgt.

7.  Informationsübertragungssystem zum Übertragen von Information mit einem Verfahren nach einem der Ansprüche 1 bis 4, wobei das System einen Sender (6) und einen Empfänger (9) zum Aussenden und Empfangen eines Strahlungsbündels mit einer gewählten Wellenlänge enthält, der Empfänger (9) einen zusammengesetzten Halbleiter-Strahlungsdetektor (18) mit einer Spitze in der Detektionsempfindlichkeit als Funktion der Wellenlänge enthält und dessen Detektionsempfindlichkeit abhängig von abfallender Detektortemperatur größer wird, dadurch gekennzeichnet, daß der Empfänger (9) Kühlmittel (15,16,17) enthält, die zum Regeln der Detektortemperatur dienen und zum progressiven Verringern der Detektortemperatur vom Anfang der Übertragung auf eine Betriebs-Endtemperatur ausgelegt ist, daß das System Startmittel enthält, die zum Einleiten der Übertragung und zum Empfangen der Information ausgelegt ist, bevor die Detektortemperatur die Betriebs-Endtemperatur erreicht und wenn die Detektionsempfindlichkeit des Detektors für die gewählten Wellenlänge des Bündels unter seinem Endwert auf der Betriebs-Endtemperatur liegt, und daß das Halbleitermaterial des Detektors (18) derart ist, daß es eine Detektionsempfindlichkeit/Temperatur-Kennlinie schafft, deren Spitze in der Detektionsempfindlichkeit bei der Temperatur am Anfang der Informationsübertragung bei einer Wellenlänge unter der gewählten Wellenlänge des Bündels auftritt und dessen Wellenlänge progressiv ansteigt wenigstens bis zur gewählten Wellenlänge während die Detektortemperatur auf die Betriebs-Endtemperatur zurückgeht.

8. Informationsübertragungssystem nach Anspruch 7, dadurch gekennzeichnet, daß der Detektor (18) ein photoleitender Kadmium-Quecksilber-Tellurid-Detektor ist, und daß die relativen Anteile von Kadmium und Quecksilber derart gewählt sind, daß die obere Abschneidwellenlänge des Detektors im wesentlichen gleich der gewählten Wellenlänge vor dem Erkalten auf die Betriebs-Endtemperatur ist.

9. Informationsübertragungssystem nach Anspruch 7 oder 8, dadurch gekennzeichnet, daß der Sender ein Infrarotlaser (6) mit 10,6 μm Wellenlänge ist zum Erzeugen des Strahlungsbündels mit der gewählten Wellenlänge.

Fig.1.

Fig.2.

Fig.3.

Fig.4.

# Fig.5.